(19) Europäisches Patentamt
European Patent Office
Office européen des brevets

(11) EP 1 640 153 A1

(12) **EUROPEAN PATENT APPLICATION**
published in accordance with Art. 158(3) EPC

(43) Date of publication:
**29.03.2006 Bulletin 2006/13**

(21) Application number: **04746838.4**

(22) Date of filing: **25.06.2004**

(51) Int Cl.:
***B32B 27/00*** *(1968.09)*

(86) International application number:
**PCT/JP2004/009369**

(87) International publication number:
**WO 2005/000579 (06.01.2005 Gazette 2005/01)**

(84) Designated Contracting States:
**AT BE BG CH CY CZ DE DK EE ES FI FR GB GR HU IE IT LI LU MC NL PL PT RO SE SI SK TR**

(30) Priority: **27.06.2003 JP 2003183693**

(71) Applicant: **ZEON CORPORATION**
**Tokyo 100-8323 (JP)**

(72) Inventors:
- **KODEMURA, Junji,**
  **c/o Zeon Corporation**
  **Tokyo 1008323 (JP)**
- **KATOH, Yutaka,**
  **c/o Zeon Corporation**
  **Tokyo 1008323 (JP)**

(74) Representative: **Vossius & Partner**
**Siebertstrasse 4**
**81675 München (DE)**

(54) **MULTILAYER BODY AND METHOD FOR PRODUCING SAME**

(57) A laminated body is disclosed which is excellent in adhesion between a molded product and a plating layer. A laminated body containing a plating layer formed on its surface of a molded product obtained by bulk polymerization of a cyclicolefin monomer in the presence of an inorganic filler by using a ruthenium catalyst. A method for producing a laminated body containing a plating layer formed on its surface, which comprises the steps of: the step of obtaining a molded product by bulk polymerization of a cyclic olefin monomer in the presence of an in organic filler by using a ruthenium catalyst; the step of etching the surface of the molded product with a permanganic acid compound; the step of applying a plating catalyst thereon; and the step of electroless plating the surface of the molded product.

EP 1 640 153 A1

## Description

### Technical Field

The present invention relates to a laminated body comprising a bulk-polymerized molded product subjected to plating and a method for producing the same.

### Background Art

Conventionally, a molded product obtained by bulk polymerization of cyclic olefin monomers such as norbornene monomers in a mold has been utilized in various fields.

Depending on the intended use, the molded product may be subjected to plating on the surface thereof to improve the outward appearance or physical properties or to add new functions. To subject the surface of the resin molded product to plating, the surface of the molded product is generally subjected to physical etching by grinding the surface of the moldedproduct or to chemical etching with an etching solution in order to secure the adhesion between the molded product and the plating. As the etching solution, a solution containing a chromic acid compound has been widely used because of its high activity. From the viewpoint of environmental safety, a solution containing a permanganic acid compound comes to be used preferably over the chromic acid compound solution in recent years.

Demand for improving the adhesion between the molded product and plating is increasing year by year. For the purpose of improving the adhesion, it is proposed that an injection-molded product is obtained by bulk polymerization of polymerizable monomers by using a metathesis catalyst containing tungsten, molybdenum or the like as a catalyst metal in the presence of an inorganic filler such as a hydroxide, oxide, halide or oxoacid salt (Japanese Patent Application Laid-Open (JP-A) No. 8-269784).

### Disclosure of Invention

When the present inventors formed a molded product according to the Examples in JP-A No. 8-269784 supra, they have found that since the activity of the catalyst was lowered by the inorganic filler, the objective molded product could not be obtained in some cases. That is, they have found that for obtaining the objective molded product, a filler of limited type should be selected in consideration of the relationship thereof with the type of the catalyst, and also that the amount of the filler added should also be optimized. It is also found that even if the objective molded product can be obtained by optimization of polymerization conditions, the molded product after formation of a plating layer thereon shows deterioration in adhesion under high-temperature environmental conditions, thus releasing the plating therefrom.

Under thesecircumstances, the present inventors have found that when a ruthenium catalyst described in JP-A No. 2002-293891 or JP-A No. 2003-55442 is used in bulk polymerization in the presence of an inorganic filler, the deterioration in catalytic activity caused by the presence of the filter hardly occurs, the flexibility in filler type and amount is increased, and thus a molded product coping with high-degree demand can be obtained. The present inventors have found that even if an etching solution containing a permanganic acid compound poor in activity is used, the resulting molded product having a plating layer formed thereon shows excellent adhesion to the plating layer, and the present invention was thereby arrived at.

According to the present invention, there is provided a laminated body containing a plating layer formed on its surface of a molded product obtained by bulk polymerization of a cyclic olefin monomer in the presence of an inorganic filler by using a ruthenium catalyst. According to the present invention, there is also provided a method for producing the laminated body containing a plating layer formed on its surface, which comprises the steps of: the step of obtaining a molded product by bulk polymerization of a cyclic olefin monomer in the presence of an in organic filler by using a ruthenium catalyst; the step of etching the surface of the molded product with a permanganic acid compound; the step of applying a plating catalyst thereon; and the step of electroless plating the surface of the molded product.

### Best Mode for Carrying Out the Invention

The molded product used in the present invention is obtained by bulk ring-opening metathesis polymerization of a cyclic olefin monomer in the presence of an inorganic filler and a ruthenium catalyst as a metathesis polymerization catalyst. In the polymerization, other additives such as a solvent, an activator, a retarder, a chain transfer agent and other organic components can be used if necessary by adding into the cyclic olefin monomer.

The cyclic olefin monomer used in the present invention is an olefin having an alicyclic structure in the molecule thereof. The alicyclic structure is a non-aromatic cyclic structure formed by carbon-carbon bonds. From the viewpoint of the number of cycles, the alicyclic structure includes monocyclic, polycyclic, condensed polycyclic and bridged cyclic structures, and a multicyclic structure as a combination thereof. The cyclic olefin monomer has one or more carbon-carbon

double bonds. From the viewpoint of the environmental stability of the resulting laminated body to heat, light, humidity or the like, the cyclic olefin monomer is preferably a monomer having one carbon-carbon double bond, more preferably a monomer having one carbon-carbon double bond in its alicyclic structure.

The number of carbon atoms constituting the alicyclic structure is not particularly limited, but is usually in the range of 4 to 30, preferably 5 to 20, more preferably 5 to 15.

The cyclic olefinmonomer includes, for example, norbornene type monomers and monocyclic hydrocarbon monomers. These cyclic olefin monomers can be used alone or as a mixture of two or more thereof. Among these monomers, use of a monomer having two alicyclic structures in combination with a monomer having four alicyclic structures is preferable because the resulting laminated body is excellent in adhesion with a plating layer thereof. In this case, the ratio of the monomer having two alicyclic structures/the monomer having four alicyclic structures, in terms of ratio by weight, is usually 5/95 to 95/5, preferably 15/85 to 85/15, more preferably 25/75 to 75/25.

The norbornene type monomer is a compound having a norbornene ring structure, and examples thereof include norbornenes, dicyclopentadienes, tetracyclododecenes and benzoindenes. These compounds may be substituted with hydrocarbon groups such as an alkyl group, alkenyl group, al kylidene group and aryl group, and polar groups such as a hydroxyl group, carboxyl group, alkoxyl group, epoxy group, glycidyl group, oxycarbonyl group, carbonyl group, amino group, ester group and carboxylic acid anhydride group. The norbornene type monomer may have another double bond in addition to the double bond in the norbornene ring.

Specific examples of the norbornene type monomer include bicyclo[2.2.1]hept-2-ene (popular name: norbornene), tricyclo[4.3.0.$1^{2,5}$]deca-3,7-diene (popular name: dicyclopentadiene), tetracyclo[4.4.0.$1^{2,5}$, $1^{7,10}$]dodec-3-ene (popular name: tetracyclododecene), 8-ethyl-tetracyclo [4.4.0.$1^{2,5}$.$1^{7,10}$]dodec-3-ene (popular name: ethyltetracyclododecene), tetracyclo[7.4.$1^{10,13}$.$0^{1,9}$.$0^{2,7}$]trideca-2,4,6,11-tetraene (popular name: methanotetrahydrofluorene (MTF)) or the like, as well as a compound having a polar group bound to the above monomer.

The monocyclic hydrocarbon monomer is a cyclic olefin monomer having one alicyclic structure, and examples thereof include monocyclic cycloalkenes such as cyclobutene, cyclopentene, cyclohexene, 3,4-dimethyl cyclopentene, 3-methyl cyclohexene, 2-(2-methylbutyl)-1-cyclohexene, cyclooctene, cycloheptene, and vinylcyclohexene; alicyclic non-conjugated dienes such as 1,4-cyclohexadiene and 1,5-cyclooctadiene; alicyclic conjugated dienes such as cyclopentadiene, cyclohexadiene and 1,3-cyclooctadiene; or the like.

In the present invention, the above-mentioned cyclic olefin monomer is polymerized in the presence of an inorganic filler to obtain a molded product by bulk polymerization.

The inorganic filler used in the present invention is not particularly limited insofar as it can undergo phase separation from the polymer to form the so-called sea-island structure. The inorganic filler is preferably inorganic particles or metallic particles which are dissolved in, or decomposed with, a chemical etching agent (an acid, an alkali, an oxidizing agent, or the like) used in chemical etching as plating pretreatment to bring about excellent adhesion between the molded product and a plating layer. These inorganic fillers are added generally as functional additives, for example a colorant or modifiers having modifying effects such as increase in strength, improvement in flame retardancy, suppression of increase in linear expansion coefficient. The inorganic filler positioned on the surface of the molded product is dissolved in, or decomposed by, the chemical etching agent, thus functioning for roughening the surface of the molded product, while the inorganic filler positioned inside of the molded product exhibits its intended functions to improve the performance of the molded product.

The inorganic particles includes metal hydroxides such as aluminum hydroxide, magnesium hydroxide, sodium hydroxide, calcium hydroxide, ferrous hydroxide, ferric hydroxide, cuprous hydroxide, cupric hydroxide, stannous hydroxide, and stannic hydroxide; metal oxides such as silicon oxide (silica), aluminum oxide, zirconium oxide, zinc oxide, magnesium oxide, titanium oxide, sodium oxide, calcium oxide, ferrous oxide, ferric oxide, cuprous oxide, cupric oxide, tin oxide, cordierite ($2MgO \cdot 2Al_2O_3 \cdot 5SiO_2$), and antimony oxide; metal chlorides such as sodium chloride, sodium bromide, calcium chloride, aluminum chloride, ferrous chloride, ferric chloride, cuprous chloride, cupric chloride, stannous chloride, stannic chloride, chlorosilane, ammonium chloride, and antimony trichloride; metal sulfates such as sodium hydrogen sulfate, sodium sulfate, calcium sulfate, and ammonium sulfate; nitrates such as sodium nitrate and calcium nitrate; phosphates such as sodium dihydrogen phosphate, sodium hydrogen phosphate, sodium phosphate, ammonium phosphate, and sodium polyphosphate; silicates (minerals) such as hydrous magnesium silicate (talc) and mica; antimonates such as sodium antimonate; carbonates such as sodium hydrogencarbonate, sodium carbonate, and calcium carbonate; sulfites such as sodium hydrogen sulfite and sodium sulfite; hypophosphites such as sodium hypophosphite and ammonium hypophosphite; phosphites such as sodium phosphite; hypohalites such as sodium hypochlorite, calcium hypochlorite, and sodium hypobromite; thiosulfites such as sodium thiosulfite, and thiosulfates such as sodium thiosulfate; halates such as sodium chlorate, calcium chlorate, and sodium bromate; halites such as sodium chlorite, calcium chlorite, and sodium bromite; perhalates such as sodium perchlorate, calcium perchlorate, and sodium perbromate; carbides such as silicon carbide and boron carbide; nitrides such as aluminum nitride, boron nitride, and silicon nitride; glass materials such as glass powder, glass cloth, glass fiber, and glass nonwoven cloth; carbon black; or the like.

Metallic particles, for example particles of aluminum, nickel, magnesium, copper, zinc and iron can also be

used as the inorganic filler.

Among these inorganic fillers, metal hydroxides and metal oxides are preferable, and the former is more preferably aluminum hydroxide and magnesium hydroxide, and the latter is more preferably silicon oxide (silica). In the present invention, the inorganic filler is preferably in a granulated form. When the inorganic filler is in a granulated form, the major axes of 1000 inorganic filler particles are observed under a scanning electron microscope, and the number-average particle diameter calculated from the determined major axes is 0.001 to 100 $\mu$m, preferably 0.01 to 50 $\mu$m, more preferably 0.1 to 20 $\mu$m, still more preferably 0.5 to 10 $\mu$m. In this range, the adhesion between the resulting molded product and a plating layer is stabilized and excellent.

The amount of the inorganic filler used is usually 1 to 500 parts by weight, preferably 5 to 400 parts by weight, more preferably 10 to 300 parts by weight, still more preferably 20 to 200 parts by weight, relative to 100 parts of the cyclic olefin monomer. An amount outside of this range is not preferable because when the amount is too low, the adhesion between the resulting molded product and a plating layer is not sufficiently excellent, while when the amount is too high, the strength of the resulting laminated body may lower.

The ruthenium catalyst used in the present invention is a catalyst containing ruthenium as a major metal component, and is not particularly limited insofar as it enables the metathesis ring-opening polymerization of the cyclic olefin monomer.

The ruthenium catalyst includes a complex having a ruthenium atom as a central atom to which a plurality of ions, atoms, multi-atom ions and/or compounds are bound.

The ruthenium catalyst is more preferably a ruthenium carbene complex. The ruthenium carbene complex is excellent in catalytic activity at the time of bulk polymerization, and is thus excellent in an ability to produce the molded product. The ruthenium carbene complex is relatively stable to oxygen and water in air and hardly inactivated, to make its production feasible in the air, and is thus preferable.

The ruthenium carbene complex is preferably a compound represented by the following formula (1) or (2):

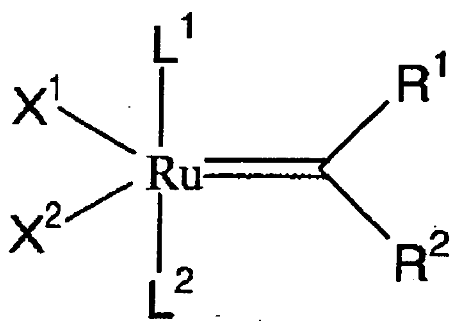

(1)

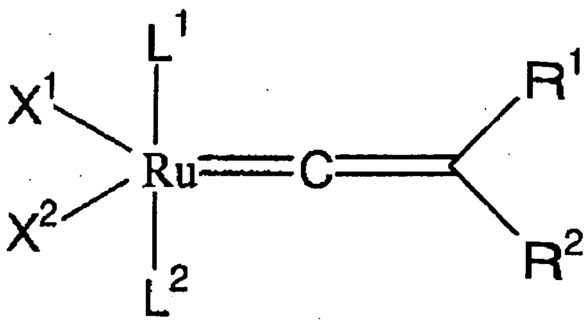

(2)

In the formulae (1) and (2), $R^1$ and $R^2$ may be the same or different, and each represent a hydrogen atom, a halogen atom, or a hydrocarbon group having 1 to 20 carbon atoms optionally containing a halogen atom, an oxygen atom, a nitrogen atom, a sulfur atom, a phosphorus atom or a silicon atom. $X^1$ and $X^2$ may be the same or different, and each represent an arbitrary anionic ligand.

$L^1$ and $L^2$ may be the same or different, and each represent a heteroatom-containing carbene compound or a neutral electron-donating compound, and at least one of $L^1$ and $L^2$ is preferably a heteroatom-containing carbene compound. In this case, the resulting ruthenium catalyst is excellent in storage stability at low temperatures and in polymerization reactivity at high temperatures, with high temperature dependence of the polymerization reaction rate, to give a molded product in good productivity.

$R^1$, $R^2$, $X^1$, $X^2$, $L^1$ and $L^2$ may be bound to one another in an arbitrary combination to form a multidentate chelate ligand.

The heteroatom is an atom other than carbon and hydrogen, and is preferably the group 15 or 16 atom in the long form of the periodic table, and specific examples thereof include N, O, P, S, As and Se atoms. Among these atoms, N, O, P and S atoms are preferable from the viewpoint of the ability to produce a stable carbene compound, and an N atom is particularlypreferable.

The heteroatom-containing carbene compound preferably has heteroatoms bound to, and adjacent to, both

sides of a carbene atom, and more preferably has a heterocycle constituted by containing a carbene carbon atom and heteroatoms in both sides of the carbene carbon atom. Preferably, the heteroatoms adjacent to the carbene carbon atom have a bulky substituent group bound thereto.

Examples of the heteroatom-containing carbene compound include compounds represented by the following formula (3) or (4) :

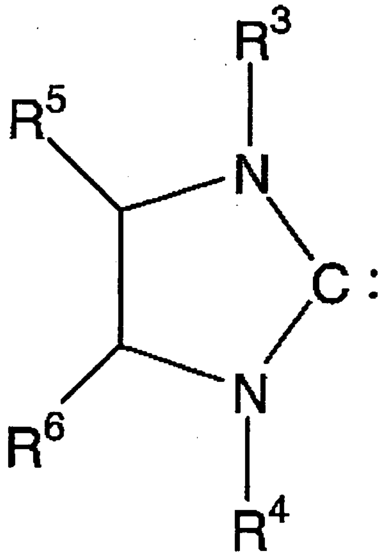

(3)

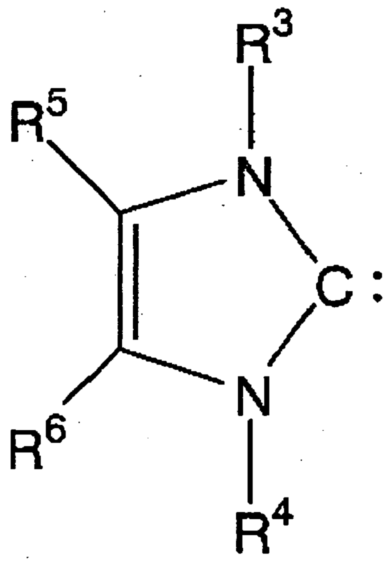

(4)

wherein $R^3$ to $R^6$ may be the same or different, and each represent a hydrogen atom, a halogen atom, or a hydrocarbon group having 1 to 20 carbon atoms optionally containing a halogen atom, an oxygen atom, a nitrogen atom, a sulfur atom, a phosphorus atom or a silicon atom, and $R^3$ to $R^6$ may be bound to each other in an arbitrary combination to form a ring.

Specific examples of the compounds represented by the formulae (3) and (4) above include 1,3-dimesitylimidazolidin-2-ylidene, 1,3-di(1-adamantyl)imidazolidin-2-ylidene, 1-cyclohexyl-3-mesitylimidazolidin-2-ylidene, 1,3-dimesityloctahydrobenzimidazol-2-ylidene, 1,3-diisopropyl-4-imidazolin-2-ylidene, 1,3-di(1-phenylethyl)-4-imidazolin-2-ylidene, and 1,3-dimesityl-2,3-dihydrobenzimidazol-2-ylidene.

In addition to the compounds represented by the formulae (3) and (4) above, it is also possible to employ, as the heteroatom-containing carbene compound, 1,3,4-triphenyl-2,3,4,5-tetrahydro-1H-1,2,4-triazol-5-ylide ne, 1,3-dicyclohexylhexahydropyrimidin-2-ylidene, N,N,N',N'-tetraisopropylformamidinylidene, 1,3,4-triphenyl-4,5-dihydro-1H-1,2,4-triazol-5-ylidene, and 3-(2,6-diisopropylphenyl)-2,3-dihydrothiazol-2-ylidene.

In the formulae (1) and (2), each of the anionic ligands $X^1$and $X^2$ is a ligand to be negatively charged upon removal from the central metal, and examples thereof include halogen atoms such as F, Cl, Br and I, a diketonate group, substituted cyclopentadienylgroup, alkoxylgroup, aryloxygroup and carboxyl group. Among these groups, a halogen atom is preferable, and a chlorine atom is more preferable.

In the formulae (1) and (2), the neutral electron-donating compound used as $L^1$ or $L^2$ may be any ligand to have neutral charge upon removal from the central metal. Specific examples include carbonyl, amines, pyridines, ethers, nitriles, esters, phosphines, thioethers, aromatic compounds, olefins, isocyanides, and thiocyanates. Among these compounds, phosphines, ethers and pyridines are preferable, and trialkyl phosphine is more preferable.

The complex compound represented by the formula (1) above includes, for example, ruthenium complex compounds having a heteroatom-containing carbene compound and a neutral electron-donating compound, such as benzylidene (1,3-dimesithylimidazolidin-2-ylidene) (tricyclohexyl phosphine) ruthenium dichloride, (1,3-dimesithylimidazolidin-2-ylidene) (3-methyl-2-buten-1-ylidene) (tricyclopentyl phosphine) ruthenium dichloride, benzylidene (1,3-dimesithyl-octahydrobenzimidazol-2-ylidene) (tricyclohexyl phosphine) ruthenium dichloride, benzylidene [1,3-di(1-phenylethyl)-4-imidazolin-2-ylidene] (tricyclohexyl phosphine) ruthenium dichloride, benzylidene (1,3-dimesithyl-2,3-dihydrobenzimidazol-2-ylidene) (tricyclohexyl phosphine) ruthenium dichloride, benzylidene (tricyclohexyl phosphine) (1,3,4-triphenyl-2,3,4,5-tetrahydro-1H-1,2,4-triazol-5-ylid ene) ruthenium dichloride, (1,3-diisopropylhexahydropyrimidin-2-ylidene)

(ethoxymethylene) (tricyclohexyl phosphine) ruthenium dichloride, and benzylidene (1,3-dimesitylimidazolidin-2-ylidene) pyridine ruthenium dichloride; and

ruthenium complex compounds having two heteroatom-containing, such as benzylidenebis(1,3-dicyclohexylimidazolidin-2-ylidene) ruthenium dichloride and benzylidenebis(1,3-diisopropyl-4-imidazolin-2-ylidene) ruthenium dichloride.

In the formula (1), the complex compound having $R^1$ bound to $L^1$ includes compounds represented by the following formulae (5) to (7):

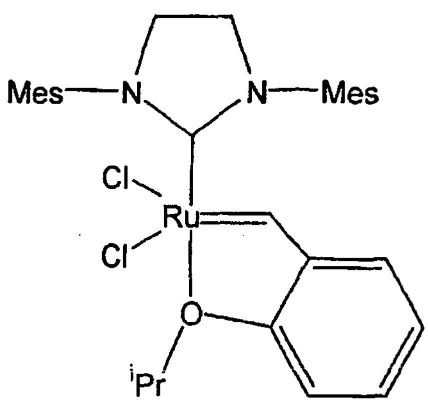

(5)

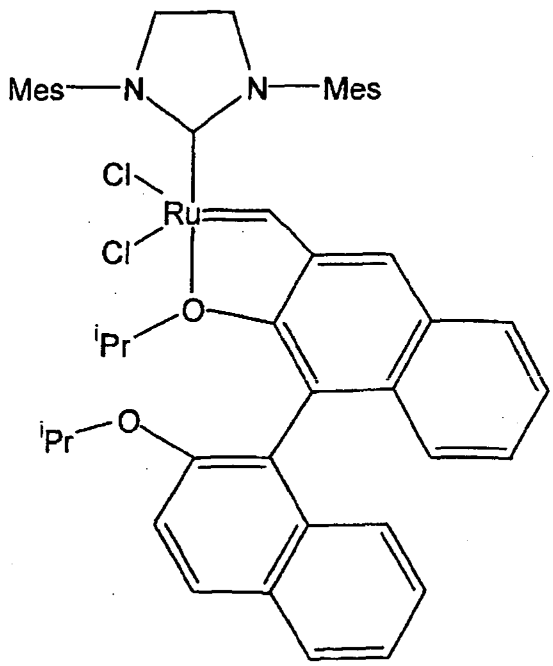

(6)

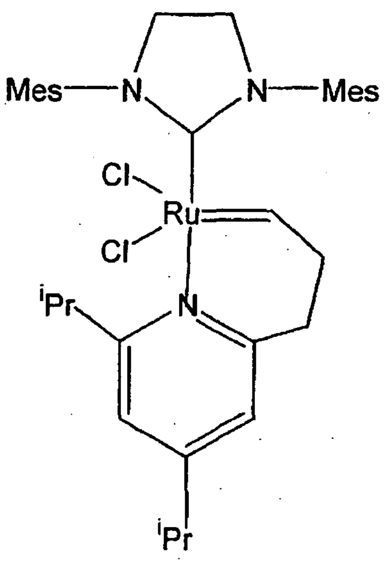

(7)

wherein the Mes group is represented by the following formula (8) :

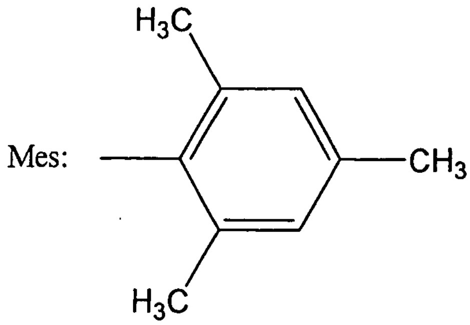

(8)

The complex compound represented by the formula (2) above includes, for example, (1,3-dimesitylimidazolidin-2-ylidene) (phenylvinylidene) (tricyclohexyl phosphine) ruthenium dichloride, (t-butylvinylidene) (1,3-diisopropyl-4-imidazolin-2-ylidene) (tricyclopentyl phosphine) ruthenium dichloride, and bis(1,3-dicyclohexyl-4-imidazolin-2-ylidene) phenyl vinylidene ruthenium dichloride.

These ruthenium complex compounds can be produced by methods described in, for example, Organic Letters, vol. 1, p. 953 (1999) and Tetrahedron Letters, vol. 40, p. 2247 (1999).

The amount of the ruthenium catalyst used, in terms of the molar ratio of (ruthenium atom in the catalyst : cyclic olefin monomer), is usually in the range of 1 : 2,000 to 1 : 2,000,000, preferably 1 : 5,000 to 1 : 1, 000, 000, more preferably 1 : 10,000 to 1 : 500,000.

The ruthenium catalyst can be used if necessary in the form of a solution in a small amount of an inert solvent. The solvent includes, for example, linear aliphatic hydrocarbons such as n-pentane, n-hexane and n-heptane; alicyclic hydrocarbons such as cyclopentane, cyclohexane, methyl cyclohexane, dimethyl cyclohexane, trimethyl cyclohexane, ethyl cyclohexane, diethyl cyclohexane, decahydronaphthalene, dicycloheptane, tricyclodecane, hexahydroindene and cyclooctane; aromatic hydrocarbons such as benzene, toluene and xylene; and nitrogen-containing hydrocarbons such as nitromethane, nitrobenzene and acetonitrile; oxygen-containing hydrocarbons such as diethyl ether and tetrahydrofuran. Preferable among these solvents are industrially widely usable aromatic hydrocarbons, linear aliphatic hydrocarbons and alicyclic hydrocarbons in which the ruthenium catalyst is excellent in solubility. Further, a liquid antioxidant, a liquid plasticizer and a liquid elastomer may be used as the inert solvent insofar as it does not lower the catalytic activity of the ruthenium catalyst.

For the purpose of regulating the polymerization activity or improving the rate of polymerization reaction, an activator (cocatalyst) or a retarder can be used in combination with the ruthenium catalyst. The activator can be exemplified by (partial) alkylation products, (partial) halogenation products, (partial) alkoxylation products and (partial) aryloxylation products of aluminum, scandium, tin, titanium, and zirconium (the term "partial" means that the activator may be a compound classified into a plurality of these "compounds").

Specific examples of the activator includes trialkoxy aluminum, triphenoxy aluminum, dialkoxyalkyl aluminum, alkoxydialkyl aluminum, trialkyl aluminum, dialkoxy aluminum chloride, alkoxyalkyl aluminum chloride, dialkyl aluminum chloride, trialkoxy scandium, tetraalkoxy titanium, tetraalkoxy tin, and tetraalkoxy zirconium.

The retarder is a compound that coordinates with ruthenium more easily than the monomer, and can be exemplified by triphenyl phosphine or the like.

The amount of the activator or retarder used can be arbitrarily set depending on the used compound and the obj ect, and usually the activator is used in the range of 1 : 0.05 to 1 : 100, preferably 1 : 0.2 to 1 : 20, more preferably 1 : 0.5 to 1 : 10, in terms of (metal atom in the ruthenium catalyst : the activator).

Any activator is preferably used in the form of a solution in the cyclic olefin monomer, but can be used as a suspension or solution in a small amount of solvent unless the properties of the objective laminated body are essentially deteriorated.

For the purpose of adjusting the molecular weight, a chain transfer agent can be added into the polymerization reaction.

For example, a compound having a carbon-carbon double bond can be used as the chain transfer agent. Specific examples thereof include vinyl norbornenes such as 2-vinyl norbornene; aliphatic olefins such as 1-hexene, 2-hexene or the like; aromatic olefins such as styrene, vinyl styrene, stilbene or the like; alicyclic olefins such as vinyl cyclohexane, vinyl cyclohexene or the like: vinyl ethers such as ethyl vinyl ether or the like; vinyl ketones such as methyl vinyl ketone or the like; ethylenically unsaturated esters such as allyl acetate, allyl methacrylate or the like; or the like.

Among these compounds, vinyl norbornenes and vinyl cyclohexene are not only chain transfer agents but also cyclic olefin monomers, but mainly act as chain transfer agents.

The amount of the chain transfer agent used is usually 0.01 to 10 wt%, preferably 0.05 to 5 wt%, more preferably 0.1 to 2 wt%, relative to the cyclic olefin monomer. When the amount of the chain transfer agent used is in this range, a molded product can be efficiently obtained.

In the present invention, a crosslinking agent can be added for the purpose of improving the physical properties of the molded product and laminated body. The crosslinking agent includes a radical generating agent, an epoxy compound, an isocyanate group-containing compound, a carboxyl group-containing compound, an acid anhydride group-containing compound, an amino group-containing compound, Lewis acid, or the like. These crosslinking agents can be used alone or as a mixture of two or more thereof. Among these compounds, a radical generating agent, an epoxy compound, an isocyanate group-containing compound, a carboxyl group-containing compound or an acid anhydride group-containing compound is preferably used, a radical generating agent, an epoxy compound or an isocyanate group-containing compound is more preferably used, and a radical generating agent such as an organic peroxide or a diazo compound or an epoxy compound is still more preferably used.

In addition to the respective components described above, other organic components such as an organic filler, an antioxidant, a UV absorber, a light stabilizer or the like may be added to the cyclic olefin monomer in the present invention.

The organic filler includes natural rubber, polybutadiene, polyisoprene, a styrene/butadiene copolymer (SBR), a styrene/butadiene/styrene block copolymer (SBS), a styrene/isoprene/styrene copolymer (SIS), an acrylonitrile/butadiene/styrene copolymer (ABS), butadiene acrylonitrile rubber (NBR), an ethylene/propylene/diene terpolymer (EPDM), an ethylene/vinyl acetate copolymer (EVA), polysulfide synthetic rubber, acrylic rubber, urethane rubber, fluorine rubber, silicone rubber, polyester elastomer, polyolefin thermoplastic elastomer, polyvinyl chloride thermoplastic elastomer, melamine resin, urea resin, and guanamine resin; cellulose resins such as cellulose nitrate, cellulose acetate, cellulose butyrate acetate, cellulose propionate, and ethyl cellulose; salts such as melamine polyphosphate, melam polyphosphate, melem polyphosphate, and a melamine/melam/melem polyphosphate double salt; or the like. Other organic components includes various plastic/rubber antioxidants such as phenol antioxidants, phosphorus-based antioxidants, and amine-based antioxidants; and light stabilizers such as benzotriazole UV absorber, benzophenone UV absorber, salicylate UV absorber, cyanoacrylate UV absorber, oxanilide UV absorber, hindered amine UV absorber, and benzoate UV absorber; or the like.

The amount of these other organic components used is usually 0.001 to 100 parts by weight relative to 100 parts of the cyclic olefin monomer.

A reaction solution containing the cyclic olefin monomer and the above-described components is first prepared and then subjected to bulk polymerization. The method of preparing the reaction solution is not limited, and there is for example a method in which a solution containing the cyclic olefin monomer (hereinafter, referred to sometimes as "monomer solution") and a solution having the ruthenium catalyst dissolved or suspended in a suitable solvent (catalyst solution) are separately prepared and then mixed with each other to prepare the reaction solution just before reaction. In this case, the inorganic filler and various kinds of additives may be added to the monomer solution or to the catalyst solution. Further, these may be added to a reaction solution obtained by mixing the monomer solution with the catalyst solution.

The method of obtaining a molded product by bulk polymerization of the above-described reaction solution includes a reaction injection molding method which involves injecting the reaction solution containing predetermined amounts of the monomer solution, the ruthenium catalyst and if necessary other components such as a chain transfer agent into a mold and curing the reaction solution.

As the mold used in the reaction injection molding method, a conventional known mold, for example, a split mold, that is, a core mold and a cavity mold can be used, and the reaction solution is injected into a gap (cavity) therebetween and subjected to bulk polymerization. The core mold and cavity mold are produced so as to form a gap adapted to the shape of the objective molded product. The shape, material and size of the mold are not particularly limited, but a metallic mold can be used to increase the rate of polymerization. The rate of polymerization is preferably higher because when the rate of polymerization is high, the inorganic filer gathers considerably on the surface of the molded product, thus easily roughening the surface of the molded product by chemical etching as plating pretreatment.

The reaction solution is injected into the cavity of the metallic mold, and bulk polymerization is allowed to progress. The temperature of the metallic mold is preferably 110 to 300°C, more preferably 120 to 300°C, still more preferably a temperature higher by at least 30°C, particularly higher by at least 50°C, than the Tg of the resulting molded product in order to roughen the surface of the molded product easily by chemical etching.

The charging pressure (injection pressure) at which the cavity is charged with the reaction solution is usually 0.01 to 10 MPa, preferably 0.02 to 5 MPa. When the charging pressure is too low, a transfer face formed on the inner periphery of the cavity tends to be not excellently transferred, while when the charging pressure is too high, the rigidity of the mold should be increased, which is not economical. The clamping pressure is usually in the range of 0.01 to 10

MPa. The polymerization time may be suitably selected, and is usually 10 seconds to 20 minutes, preferably within 5 minutes.

In the present invention, a plating layer is formed on the surface of the molded product thus obtained.

Formation of the plating layer is carried out usually by electroless plating and if necessary the thickness of the plating layer may be increased by further electrolytic plating.

After electroless plating, the plating layer can be heated and pressurized to improve the adhesion between the molded product and the plating layer.

Generally, a plating catalyst such as silver, palladium, zinc or cobalt is allowed to adhere to the surface of the molded product prior to electroless plating.

For allowing a plating adhere to the molded product, plating pretreatment is generally conducted. Such pretreatment includes a degreasing step, a chemical etching step, a step of applying a catalyst and an activation step. In the present invention, a general method is used as the pretreatment method.

In the decreasing step, oil and fat dirt adhering to the surface of the molded product is removed by alkali degreasing, solvent degreasing, emulsion degreasing, electrolytic degreasing or mechanical degreasing to clean the surface.

In the chemical etching step, a chemical etching solution containing a permanganic acid compound, a chromic acid compound or a ferric chloride compound is used. A laminated body obtained by etching the molded product with a permanganic acid compound is preferable because it exhibits excellent adhesion to the plating layer. Specifically, the method of etching with the permanganic acid compound includes a method which comprises contacting an alkaline aqueous solution such as an aqueous potassiumpermanganate solution or an aqueous sodiumpermanganate solution with the molded product and then neutralizing and reducing it with an acidic aqueous solution such as a mixture of hydroxylamine sulfate and sulfuric acid.

In the step of applying the catalyst and the activation step, the molded product is soaked in a solution containing a metal such as silver, palladium, zinc or cobalt, or a salt or complex thereof, dissolved at a concentration of 0.001 to 10 wt% in water or an organic solvent such as alcohol or chloroform (which may contain an acid, an alkali, a complexing agent or a reducing agent if necessary), followed by reduction of the metal, whereby the plating catalyst is stuck and activated on the surface of the molded product.

In the case of electroless plating, a plating inducer is contacted with the surface of the molded product after chemical etching and before the step of applying the catalyst. As the plating inducer, a known plating inducer can be used, and examples thereof include an electroconductive material consisting of an electroconductive polymer or its precursor and water or a polar solvent (JP-A No. 2002-26014), a composition consisting of a soluble palladium salt, a water-soluble solvent and water (JP-A No. 7-131135), a material containing a photosensitive palladium polymeric chelate compound (JP-ANo. 2000-147762), and a compound having an unshared electron pair, such as a compound having an amino group, thiol group, carboxyl group or cyano group capable of chelat ing with a metal atom or metal ion, a heterocyclic compound having an ability to coordinate with a metal atom or metal ion (WO 03/072851). Among these, the compound having an unshared electron pair is preferable because of its excellent adhesion to the molded product. Preferable examples of the compound having an unshared electron pair include imidazoles such as 2-methyl imidazole and 1- (2-aminoethyl) -2-methyl imidazole; pyrazole and pyrazole derivatives such as 3-amino-4-cyanopyrazole; triazoles such as 1,2,4-triazole and 2-amino-1,2,4-triazole; triazines such as 2-aminotriazine; or the like.

After the molded product is subjected to the pretreatment described above, the molded product is subjected to electroless plating by soaking it in a plating bath containing an electroless plating solution. The conditions for electroless plating may be set depending on the polishing solution.

The electroless plating solution used in the electroless plating method is not particularly limited, and a known autocatalytic electroless plating solution can be used. For example, it is possible to use an electroless plating solution such as: an electroless copper plating solution using ammonium hypophosphite, hypophosphorous acid, ammonium borohydride, hydrazine or formalin as a reducing agent; an electroless nickel/phosphorus plating solution using sodium hypophosphite as a reducing agent, an electroless nickel/boron plating solution using dimethyl aminoborane as a reducing agent; an electroless palladiumplating solution; an electroless palladium-phosphorus plating solution using sodium hypophosphite as a reducing agent, an electroless gold plating solution; an electroless silver plating solution; or an electroless nickel/cobalt/phosphorus plating solution using sodium hypophosphite as a reducing agent. For the purpose of the stability of the plating solution and adjusting of plating precipitation, a known complexing agent such as tartaric acid, ethylenediaminetetraacetic acid, citric acid, and acetic acid, a buffer agent such as boric acid, and a pH adjusting agent such as caustic soda may be suitably added to the electroless plating bath.

The thickness of the plating layer thus formed on the surface of the molded product is not particularly limited, and can be arbitrarily set depending on the intended use of the laminated body having a plating layer formed thereon.

The plating layer may be formed so as to cover the whole of the molded product or may be formed in arbitrary pattern on the surface of the molded product.

The method of forming a patterned plating layer includes (1) a method of forming a patterned plating layer,

which comprises subj ecting the whole surface of the molded product to electroless plating, then forming a resist pattern thereon by using a plating resist, allowing a metallic layer to grow via the resist pattern by electrolytic plating, then removing the resist, and removing an unnecessary electroless plating by etching treatment, and (2) a method which comprises subj ecting the surface of the molded product to electroless plating in desired pattern to form a metal pattern. In either method, a plating layer may further grow by electrolytic plating if necessary on the plating layer formed by electroless plating.

In the method (2), an initiator pattern consisting of the above-mentioned plating inducer is formed, and the molded product is subjected to plating along this initiator pattern, whereby a metal pattern can be easily obtained (JP-A No. 7-263841).

The method of forming an initiator pattern is preferably a method of allowing the above-mentioned plating inducer to adhere directly in a patterned form to the surface of the molded product. The adhesion method includes a method in which the plating inducer is dissolved or suspended in a solvent if necessary and allowed to adhere directly in a patterned form to the surface of the molded product. The adhesion method can include known plating adhesion methods such as an ink jet system of jetting a liquid, a screen printing system of printing via a mask, and a dispenser application system of directly applying a liquid. When the preferable compound having an unshared electron pair is used as a plating inducer, the plating inducer is used preferably in the form of a solution or suspension in water or polar compounds; ethers such as tetrahydrofuran; alcohols such as ethanol and isopropyl alcohol; ketones such as acetone and methyl ethyl ketone; cellosolves such as ethyl cellosolve acetate.

When the above-mentioned plating inducer is used, the plating catalyst is applied selectively to the site where the plating inducer adheres, so an initiator pattern is formed from the plating inductor, then the plating catalyst is applied thereto, electroless plating is carried out, and if necessary, electrolytic plating is further carried out, whereby a patterned plating layer can be formed on the surface of the molded product.

After plating, annealing treatment can be carried out to increase the adhesion between the molded product and the plating layer. The annealing treatment exhibits a significant effect particularly when the amount of the inorganic filler is 70 parts by weight or more, preferably 80 parts by weight or more, based on 100 pars by weight of the total cyclic olefin monomers. The annealing treatment is conducted usually by heating to a temperature of not lower than the Tg of the polymer constituting the molded product obtained by polymerization, and the upper limit of the heating temperature is usually Tg + 200°C, preferably Tg + 150°C. The annealing treatment time is usually 1 to 120 minutes, preferably 3 to 60 minutes, more preferably 5 to 45 minutes.

The laminated body obtained in this manner is excellent not only in various characteristics such as dielectric characteristics (low dielectric constant, low dielectric loss tangent), heat resistance, low water absorption, and chemical resistance, but also in adhesion of the plating layer, insulation reliability and productivity, and can thus be used preferably in molded products having a decorative plating, for example electronic part materials such as a prepreg, a print circuit board, an insulation sheet, an interlayer insulation film, and an antenna substrate, and a bumper.

Examples

Hereinafter, the present invention is described in more detail by reference to the Examples and Comparative Examples. In the Examples, parts and % are expressed on a weight basis unless otherwise specified.

(1) Polymerization conversion

Polymerization conversion was judged based on the degree of polymerization conversion under the following criteria:

◎: $C \geq 98\%$
○: $95\% \leq C < 98\%$
Δ: $92\% \leq C < 95\%$
×: $C < 92\%$

The amount of gas generated from a molded product was measured by thermogravimetric analysis (TGA at heating rate 10°C/min. from 30°C to 260° in a nitrogen atmosphere), and the degree of polymerization conversion was calculated according to the following equation:

Degree of polymerization conversion (C) = 100 - (amount of gas × ((weight of inorganic filler incorporated + amount of monomer incorporated)/(weight of monomer incorporated))

(2) Adhesion

According to JIS Test Method C5012, a flat laminated body having a plating layer formed thereon was measured for adhesion (P) between the molded product and the plating layer. Measurement of the adhesion was carried out before and after annealing treatment at 170°C × 30 minutes. The adhesion was judged under the following criteria:

◎: $P \geq 1.0$ kN/m
○: 0.7 kN/m $\leq P <$ 1.0 kN/m
Δ: 0.4 kN/m $\leq P <$ 0.7 kN/m
×: $P <$ 0.4 kN/m

(3) Insulation reliability

A laminated body was cut into a test piece of 20 mm × 20 mm, and this test piece was placed for 1000 hours in a thermostatic humidistat under the conditions of 60°C×95% RH, and the difference (D) in dielectric loss tangent before and after the test was determined and judged under the following criteria:

◎: $D \leq 0.001$
○: $0.001 \leq D < 0.002$
Δ: $0.002 \leq D < 0.003$
×: $D > 0.003$

The dielectric loss tangent was measured at 1 GHz with RF Impedance/Material Analyzer E4991A (manufactured by Agilent Technology).

(4) Solvent resistance

A laminated body was cut into a test piece of 20 mm × 20 mm, and this test piece was soaked in toluene at room temperature for 24 hours, and the degree of swelling of the molded product was calculated according to the equation: S (%) = ((difference of the weight of the molded product before-after soaking)/ the weight of the molded product before soaking), and judged under the following criteria:

◎: $D < 50\%$
○: $50\% \leq D < 100\%$
Δ: $100 \leq D < 150\%$
×: $D \geq 150\%$ or dissolved

Example 1

0.17 part of benzylidene(1,3-dimesitylimidazolidin-2-ylidene) (tricyclohexyl phosphine) ruthenium dichloride and 0.26 part of triphenyl phosphine were dissolved in 3. 67 parts of toluene to prepare a ruthenium catalyst solution containing ruthenium at a ruthenium concentration of 0.05 mol/L.

Then, 2 parts of a phenol antioxidant (trade name: Irganox 1330, manufactured by Ciba-Geigy Japan Limited), 6 parts of a styrene/isoprene/styrene copolymer (SIS; Quintac 3421, manufactured by ZEON CORPORATION) as another organic component, 100 parts of silica (SO-E2, manufactured by ADMATECHS CO., LTD) and 1 part of an aluminate-based dispersant (AL-M, manufactured by Ajinomoto Inc.) as inorganic fillers, and 1 part of vinyltrimethoxy silane were added to mixed cyclic olefin monomers consisting of 70 parts of tetracyclododecene (TCD) and 30 parts of norbornene (NB), and the mixture was stirred for 5 minutes with a planetary stirring machine. The resulting monomer solution was cooled to 10°C, and then 0.4 part of the solution of the ruthenium catalyst in toluene prepared above (catalyst amount, 0.02 mmol; chlorine content, 0.04 mmol) was added thereto, and the mixture was further stirred for 10 seconds

with the planetary stirring machine and then immediately injected into an SUS mold having a space volume of 200 mm × 200 mm × 2 mm, previously heated at 200°C. The injection time was about 3 seconds, and the reaction was carried out for 3 minutes in the mold. A series of these procedures were carried out in a nitrogen atmosphere. The polymerization conversion, insulation reliability and solvent resistance of the resulting flat molded product are shown in Table 1.

Then, the resulting flat molded product was soaked for 5 minutes in an aqueous solution having concentrations of 60 g/L $KMnO_4$ and 40 g/L NaOH at 70°C. After soaking in $KMnO_4$, the molded product was neutralized by soaking in an aqueous solution having concentrations of 30 g/L $SnCl_2$ and 300ml/LHCl for 5 minutes, to form a roughened embossed shape on the surface of the flat molded product. Then, the molded product was soaked at room temperature for 10 minutes in HS-202B (manufactured by Hitachi Chemical Co., Ltd.), that is, an electroless plating catalyst containing $PdCl_2$, then washed with water, soaked at 70°C for 30 minutes in an L-59 electroless plating solution (manufactured by Hitachi Chemical Co., Ltd.) and further subjected to electrolytic plating with copper sulfate to form a plating layer of 20 μm in thickness on the surface of the flat molded product thereby giving a flat laminated body. Then, the resulting flat laminated body was annealed in an inert oven at 170°C for 30 minutes and measured for adhesion before and after annealing. The results are shown in Table 1.

Example 2

A flat molded product was obtained in the same manner as in Example 1 except that SIS was not added as another organic component. The polymerization conversion, insulation reliability and solvent resistance of the resulting flat molded product are shown in Table 1. A plating layer was formed with the same formulation as in Example 1 to give a flat laminated body which was then measured for adhesion before and after annealing. The results are shown in Table 1.

Example 3

A flat molded product was obtained in the same manner as in Example 2 except that the inorganic filler was replaced by aluminum hydroxide (HIGILITE H-34, manufactured by Showa Denko K.K.). The polymerization conversion, insulation reliability and solvent resistance of the resulting flat molded product are shown in Table 1. A plating layer was formed with the same formulation as in Example 1 to give a flat laminated body which was then measured for adhesion before and after annealing. The results are shown in Table 1.

Example 4

A flat molded product was obtained in the same manner as in Example 2 except that 100 parts of tetracyclododecene (TCD) only was used as the cyclic olefin monomer. The polymerization conversion, insulation reliability and solvent resistance of the resulting flat molded product are shown in Table 1. A plating layer was formed with the same formulation as in Example 1 to give a flat laminated body which was then measured for adhesion before and after annealing. The results are shown in Table 1.

Example 5

A flat molded product was obtained in the same manner as in Example 2 except that 100 parts of dicyclopentadiene (DCP) only was used as the cyclic olefin monomer. The polymerization conversion, insulation reliability and solvent resistance of the resulting flat molded product are shown in Table 1. A plating layer was formed with the same formulation as in Example 1 to give a flat laminated body which was then measured for adhesion before and after annealing. The results are shown in Table 1.

Example 6

A flat molded product was obtained in the same manner as in Example 5 except that the amount of silica was changed into 50 parts, and the mold temperature was changed from 200°C to 150°C. The polymerization conversion, insulation reliability and solvent resistance of the resulting flat molded product are shown in Table 1. A plating layer was formed with the same formulation as in Example 1 to give a flat laminated body which was then measured for adhesion before and after annealing. The results are shown in Table 1.

Comparative Example 1

A flat molded product was obtained in the same manner as in Example 1 except that 10 mM trisdodecyl ammonium molybdate was used as the catalyst, and 46 mM (chlorine content 4.6 mmol) diethyl aluminum chloride and

46.9 mM 1,3-dichloro-2-propanol were added as catalyst activators. The polymerization conversion, insulation reliability and solvent resistance of the resulting flat molded product are shown in Table 1. A plating layer was formed with the same formulation as in Example 1 to give a flat laminated body which was then measured for adhesion before and after annealing. The results are shown in Table 1.

Comparative Example 2

A flat molded product was obtained in the same manner as in Comparative Example 1 except that 100 parts of dicyclopentadiene were used as the monomer, and the mold temperature was changed to 150°C. The polymerization convers ion, insulation reliability and solvent resistance of the resulting flat molded product are shown in Table 1. A plating layer was formed with the same formulation as in Example 1 to give a flat laminated body which was then measured for adhesion before and after annealing. The results are shown in Table 1.

Comparative Example 3

A flat molded product was obtained in the same manner as in Comparative Example 2 except that SIS was not added as another organic component. The polymerization conversion, insulation reliability and solvent resistance of the resulting flat molded product are shown in Table 1. A plating layer was formed with the same formulation as in Example 1 to give a flat laminated body which was then measured for adhesion before and after annealing. The results are shown in Table 1.

Comparative Example 4

A flat molded product was obtained in the same manner as in Comparative Example 3 except that the inorganic filler used was aluminum hydroxide (HIGILITE H-34, manufactured by Showa Denko K.K.), and the mold temperature was changed to 200°C. The polymerization conversion, insulation reliability and solvent resistance of the resulting flat molded product are shown in Table 1. A plating layer was formed with the same formulation as in Example 1 to give a flat laminated body which was then measured for adhesion before and after annealing. The results are shown in Table 1.

| | | Composition | | | | Molding temperature (℃) | Evaluation | | | | |
|---|---|---|---|---|---|---|---|---|---|---|---|
| | | Catalyst metal | Monomer (parts) | Inorganic filler (parts) | Another organic component (parts) | | Polymerization conversion | Adhesion | | Insulation reliability | Solvent resistance |
| | | | | | | | | Before annealing | After annealing | | |
| Examples | 1 | Ru | TCD/NB (70/30) | $SiO_2$ (100) | SIS (6) | 200 | ◎ | ◎ | ◎ | ◎ | ◎ |
| | 2 | Ru | TCD/NB (70/30) | $SiO_2$ (100) | | 200 | ◎ | ◎ | ◎ | ◎ | ◎ |
| | 3 | Ru | TCD/NB (70/30) | $Al(OH)_3$ (100) | | 200 | ◎ | ◎ | ◎ | ◎ | ◎ |
| | 4 | Ru | TCD (100) | $SiO_2$ (100) | | 200 | ○ | ○ | ◎ | ◎ | ◎ |
| | 5 | Ru | DCP (100) | $SiO_2$ (100) | | 200 | ○ | ○ | ○ | ○ | ○ |
| | 6 | Ru | DCP (100) | $SiO_2$ (50) | | 150 | ○ | ○ | Δ | ○ | ○ |
| Comparative Examples | 1 | Mo | TCD/NB (70/30) | $SiO_2$ (100) | SIS (6) | 200 | Δ | × | × | × | × |
| | 2 | Mo | DCP (100) | $SiO_2$ (100) | SIS (6) | 150 | Δ | × | × | × | × |
| | 3 | Mo | DCP (100) | $SiO_2$ (100) | | 150 | × | Δ | × | × | × |
| | 4 | Mo | DCP (100) | $Al(OH)_3$ (100) | | 200 | × | Δ | × | × | × |

As shown in Table 1, it was found that the laminated bodies of the present invention (Examples 1 to 6) are endowed with excellent adhesion between the plating layer and the molded product by etching with permanganic acid, and exhibit high insulation reliability and solvent resistance. The case (Example 4) where tetracyclododecene having one carbon-carbon double bond was used can be seen to be superior in adhesion after annealing treatment, insulation reliability and solvent resistance to the case (Example 5) where a monomer having two carbon-carbon double bonds, such as dicyclopentadiene, was used. The cases (Examples 1 to 3) where norbornene, that is, a monomer having two alicyclic structures, and tetracyclododecene, that is, a monomer having four alicyclic structures, were used can be seen to be excellent in any characteristics.

On one hand, the cases (Comparative Examples 1 to 4) where a molybdenum-based catalyst was used can be seen to be poor in polymerization conversion, inferior in adhesion after etching with permanganic acid, poor in the degree of polymerization conversion, and thus inferior in insulation reliability and solvent resistance.

## Claims

1. A laminated body containing a plating layer formed on its surface of a molded product obtained by bulk polymerization of a cyclic olefin monomer in the presence of an inorganic filler by using a ruthenium catalyst.

2. The laminated body according to claim 1, wherein the ruthenium catalyst is a ruthenium carbene complex.

3. The laminated body according to claim 1, wherein the inorganic filler is a metal hydroxide or a metal oxide.

4. The laminated body according to claim 1, wherein the cyclic olefin monomer contains only one double bond therein.

5. The laminated body according to claim 1, wherein the bulk polymerization is carried out in the presence of a chain transfer agent.

6. The laminated body according to claim 1, wherein the molded product is formed in a metallic mold at the temperature of 110°C or more.

7. The laminated body according to claim 1, wherein the molded product is obtained by bulk polymerization using a reaction injection molding method.

8. The laminated body according to claim 1, wherein the plating layer is formed by electroless plating.

9. A method for producing a laminated body containing a plating layer formed on its surface, which comprises the steps of:

   the step of obtaining a molded product by bulk polymerization of a cyclic olefin monomer in the presence of an in organic filler by using a ruthenium catalyst;
   the step of etching the surface of the molded product with a permanganic acid compound;
   the step of applying a plating catalyst thereon; and
   the step of electroless plating the surface of the molded product.

**INTERNATIONAL SEARCH REPORT**

International application No. PCT/JP2004/009369

A. CLASSIFICATION OF SUBJECT MATTER
Int.Cl[7] B32B27/00

According to International Patent Classification (IPC) or to both national classification and IPC

B. FIELDS SEARCHED

Minimum documentation searched (classification system followed by classification symbols)
Int.Cl[7] B32B1/00-35/00, C08G61/08, B29C45/00

Documentation searched other than minimum documentation to the extent that such documents are included in the fields searched

| | | | |
|---|---|---|---|
| Jitsuyo Shinan Koho | 1926-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2001-326434 A (Nippon Zeon Co., Ltd.), 22 November, 2001 (22.11.01), Claims; Par. No. [0032] (Family: none) | 1-9 |
| Y | JP 8-269784 A (Nippon Zeon Co., Ltd.), 15 October, 1996 (15.10.96), Claims (Family: none) | 1-9 |
| Y | JP 2002-338664 A (Nippon Zeon Co., Ltd.), 27 November, 2002 (27.11.02), Claims; Par. No. [0031] (Family: none) | 1-9 |

[X] Further documents are listed in the continuation of Box C. [ ] See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 01 October, 2004 (01.10.04) | 19 October, 2004 (19.10.04) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

International application No.
PCT/JP2004/009369

C (Continuation). DOCUMENTS CONSIDERED TO BE RELEVANT

| Category* | Citation of document, with indication, where appropriate, of the relevant passages | Relevant to claim No. |
|---|---|---|
| A | JP 2003-155331 A (Hitachi Kasei Kabushiki Kaisha), 27 May, 2003 (27.05.03), (Family: none) | 1-9 |
| A | JP 2003-55442 A (Sekisui Chemical Co., Ltd.), 26 February, 2003 (26.02.03), (Family: none) | 1-9 |

Form PCT/ISA/210 (continuation of second sheet) (January 2004)